# FASCICULE DE BREVET EUROPEEN

(11) **EP 3 410 482 B1**
(45) Date de publication et mention de la délivrance du brevet: **18.11.2020**
(21) Numéro de dépôt: 18173288.4
(22) Date de dépôt: 30.06.2015
(51) Int. Cl.: H01L 25/16, H01L 27/15, H01L 33/18, H05B 45/48, H01L 33/08, H01L 33/20, H01L 33/24, H01L 33/38, H01L 33/44, H01L 33/62

(54) **DISPOSITIF OPTOÉLECTRONIQUE COMPRENANT DES DIODES ÉLECTROLUMINESCENTES SUR UN CIRCUIT DE COMMANDE**
OPTOELEKTRONISCHE VORRICHTUNG MIT LEUCHTDIODEN AUF EINEM STEUERSCHALTKREIS
OPTOELECTRONIC DEVICE WITH LIGHT EMITTING DIODES ON A CONTROL CIRCUIT

(30) Priorité: 30.06.2014 FR 1456178
(43) Date de publication de la demande: 05.12.2018
(62) Demande divisionnaire de: 15733702.3
(73) Titulaire: Aledia, 38040 Grenoble (FR)
(72) Inventeur: MERCIER, Frédéric, 38500 SAINT NICOLAS DE MACHERIN (FR); GILET, Philippe, 38470 TECHE (FR); HUGON, Xavier, 38470 TECHE (FR)
(74) Mandataire: Cabinet Beaumont

(56) Documents cités:
- EP-A1- 2 357 676
- EP-A2- 2 665 100
- US-A1- 2003 013 217
- US-A1- 2011 126 891
- US-A1- 2011 254 034
- US-B1- 8 624 968
- RENJIE WANG ET AL: "Color-tunable, phosphor-free InGaN nanowire light-emitting diode arrays monolithically integrated on silicon", OPTICS EXPRESS, vol. 22, no. S7, 1 janvier 2014 (2014-01-01), page A1768, XP055155362, DOI: 10.1364/OE.22.0A1768

## Description

Le présent brevet revendique la priorité de la demande de brevet français FR14/56178.

### Domaine

La présente invention concerne de façon générale les dispositifs optoélectroniques à base de matériaux semiconducteurs et leurs procédés de fabrication. La présente invention concerne plus particulièrement les dispositifs optoélectroniques comprenant des diodes électroluminescentes formées par des éléments tridimensionnels, notamment des microfils ou nanofils semiconducteurs.

### Exposé de l'art antérieur

Par dispositifs optoélectroniques à diodes électroluminescentes, on entend des dispositifs adaptés à effectuer la conversion d'un signal électrique en un rayonnement électromagnétique, et notamment des dispositifs dédiés à l'émission d'un rayonnement électromagnétique, notamment de la lumière. Des exemples d'éléments tridimensionnels adaptés à la réalisation de diodes électroluminescentes sont des microfils ou nanofils comprenant un matériau semiconducteur à base d'un composé comportant majoritairement au moins un élément du groupe III et un élément du groupe V (par exemple du nitrure de gallium GaN), appelé par la suite composé III-V, ou comportant majoritairement au moins un élément du groupe II et un élément du groupe VI (par exemple de l'oxyde de zinc ZnO), appelé par la suite composé II-VI.

Un dispositif optoélectronique peut comprendre plusieurs diodes électroluminescentes et un circuit de commande des diodes électroluminescentes.

Le document US 2011/0254034 A1 décrit des dispositifs optoélectroniques de ce type à base de diodes électroluminescentes nano-filaires pouvant émettre à différentes longueurs d'onde.

A titre d'exemple, il peut être souhaitable d'alimenter le dispositif optoélectronique avec une tension alternative, notamment la tension du secteur. Le circuit de commande des diodes électroluminescentes peut alors être adapté à redresser la tension alternative et à alimenter de façon sélective les diodes électroluminescentes pour s'adapter à la tension instantanée aux bornes du dispositif et, par exemple, contribuer à réduire les phénomènes de vacillement (en anglais « flickering ») de la lumière émise par les diodes électroluminescentes. Le document WO 2013/110029 A1 décrit un dispositif optoélectronique de ce type. Les diodes électroluminescentes correspondent à des composants optoélectroniques discrets qui peuvent comprendre chacun une ou plusieurs diodes électroluminescentes. Le circuit de commande peut correspondre à un circuit intégré auquel sont connectés les composants optoélectroniques.

Un inconvénient est que le nombre de diodes électroluminescentes connectées au circuit intégré est limité par l'encombrement des composants optoélectroniques et l'écartement minimal devant être maintenu entre les composants optoélectroniques. En outre, le procédé de fabrication du dispositif optoélectronique peut être complexe dans la mesure où il comprend des étapes de connexion de chaque composant optoélectronique au circuit de commande.

### Résumé

Ainsi, un objet d'un mode de réalisation est de pallier au moins en partie les inconvénients des dispositifs optoélectroniques à diodes électroluminescentes décrits précédemment et de leurs procédés de fabrication.

Un autre objet d'un mode de réalisation est d'augmenter la compacité du dispositif optoélectronique en réduisant l'espace occupé par les diodes électroluminescentes.

Un autre objet d'un mode de réalisation est de réduire l'encombrement du dispositif optoélectronique comprenant des diodes électroluminescentes montées en série.

Un autre objet d'un mode de réalisation est de réduire le nombre d'étapes du procédé de fabrication d'un dispositif optoélectronique.

Un autre objet d'un mode de réalisation est que les dispositifs optoélectroniques à diodes électroluminescentes puissent être fabriqués à une échelle industrielle et à bas coût.

Ainsi, la présente invention prévoit un dispositif optoélectronique conformément à la revendication 1 en annexe, le dispositif comprenant :
un premier circuit intégré comprenant un support comprenant des première et deuxième faces opposées, des groupes d'ensembles de diodes électroluminescentes reposant sur la première face dont des premier et deuxième ensembles, chaque groupe comprenant au moins un ensemble de diodes électroluminescentes connectées en parallèle entre des première et deuxième bornes, chaque ensemble de diodes électroluminescentes comprenant un élément semiconducteur filaire ou plusieurs éléments semiconducteurs filaires connectés en parallèle, le premier ensemble étant adapté à émettre une lumière à une première longueur d'onde et le deuxième ensemble étant adapté à émettre une lumière à une deuxième longueur d'onde différente de la première longueur d'onde, le premier circuit intégré comprenant, en outre, dans le support, des premiers éléments d'isolation électrique latérale de portions du support autour de chaque ensemble, et, sur la deuxième face, pour chaque groupe, au moins un premier plot conducteur relié à la première borne du groupe et un deuxième plot conducteur relié à la deuxième borne du groupe ; et
un deuxième circuit intégré comprenant des troisième et quatrième faces opposées, des troisièmes plots conducteurs sur la troisième face reliés électriquement aux premiers et deuxièmes plots conducteurs,
   le premier circuit intégré étant fixé sur la troisième face du deuxième circuit intégré.

Des modes de réalisation avantageux de la présente invention font l'objet des revendications dépendantes en annexe. Selon un mode de réalisation, le support comprend un substrat comprenant des cinquième et sixième faces opposées, les diodes électroluminescentes étant situées du côté de la cinquième face, et comprenant, pour chaque ensemble, au moins un deuxième élément conducteur isolé du substrat et traversant le substrat depuis la cinquième face jusqu'à la sixième face et connecté à l'un des premiers plots conducteurs.

Selon un mode de réalisation, les premiers éléments sont adaptés à isoler électriquement latéralement des portions du substrat sous-jacentes aux diodes électroluminescentes de chaque ensemble.

Selon un mode de réalisation, les premiers éléments comprennent des murs isolants s'étendant dans le substrat depuis la cinquième face jusqu'à la sixième face.

Selon un mode de réalisation, le deuxième circuit intégré comprend des drains thermiques traversant le deuxième circuit intégré depuis la troisième face jusqu'à la quatrième face.

Selon un mode de réalisation, le dispositif comprend, pour chaque ensemble, une couche d'électrode recouvrant chaque diode électroluminescente dudit ensemble et comprend, en outre, une couche conductrice recouvrant la couche d'électrode autour des diodes électroluminescentes dudit ensemble.

Selon un mode de réalisation, le deuxième élément est en contact avec la couche conductrice ou la couche d'électrode.

Selon un mode de réalisation, le deuxième circuit intégré comprend un circuit redresseur destiné à recevoir une tension alternative.

Selon un mode de réalisation, le premier circuit intégré comprend N groupes d'ensembles de diodes électroluminescentes, où N est un nombre entier variant de 2 à 200, et le deuxième circuit intégré comprend N-1 interrupteurs, chaque interrupteur étant relié à la première borne ou la deuxième borne d'un desdits groupes.

Selon un mode de réalisation, le deuxième circuit intégré comprend N sources de courant, chacune de N-1 desdites sources de courant étant reliée à la première ou deuxième borne d'un desdits groupes.

Selon un mode de réalisation, le dispositif comprend des quatrièmes plots conducteurs sur la quatrième face.

Selon un mode de réalisation, le dispositif comprend en outre un troisième ensemble de diodes électroluminescentes adapté à émettre une lumière à une troisième longueur d'onde différente de la première longueur d'onde et de la deuxième longueur d'onde.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un mode de réalisation d'un dispositif optoélectronique à diodes électroluminescentes ;
la figure 2 est une vue de détail de la figure 1 d'un mode de réalisation des diodes électroluminescentes à microfils ou nanofils ;
la figure 3 est une vue en coupe, partielle et schématique, d'un autre mode de réalisation d'un dispositif optoélectronique à diodes électroluminescentes à microfils ou nanofils ;
la figure 4 est une vue de dessus en coupe, partielle et schématique, du dispositif optoélectronique de la figure 1 ;
les figures 5 à 8 sont des vues en coupe, partielles et schématiques, d'autres modes de réalisation d'un dispositif optoélectronique à diodes électroluminescentes à microfils ou nanofils ; et
les figures 9 et 10 sont des schémas de modes de réalisation du circuit de commande du dispositif optoélectronique représenté en figure 1.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle. En outre, seuls les éléments utiles à la compréhension de la présente description ont été représentés et sont décrits. En particulier, les circuits logiques du circuit de commande du dispositif optoélectronique décrit ci-après sont à la portée de l'homme de l'art et ne sont pas décrits en détail.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

La présente description concerne des dispositifs optoélectroniques comprenant des diodes électroluminescentes formées à partir d'éléments tridimensionnels, par exemple des microfils ou des nanofils, en accord avec la présente invention telle que définie par les revendications en annexe; ou, à titre d'alternative ne faisant toutefois pas partie de la présente invention mais illustrant son contexte, des éléments coniques ou des éléments tronconiques. Dans la suite de la description et en accord avec la présente invention telle que définie par les revendications en annexe, des modes de réalisation sont décrits pour des diodes électroluminescentes formées à partir de microfils ou de nanofils. À titre d'alternative ne faisant pas partie de la présente invention telle que définie par les revendications en annexe mais illustrant son contexte, ces modes de réalisation peuvent être mis en oeuvre pour des éléments tridimensionnels autres que des microfils ou des nanofils, par exemple des éléments tridimensionnels en forme de pyramide.

Le terme "microfil" ou "nanofil" désigne une structure tridimensionnelle de forme allongée, en l'occurrence filaire, selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

Selon la présente invention, il est prévu un dispositif optoélectronique comprenant au moins deux circuits intégrés, également appelés puces. Le premier circuit intégré comprend au moins deux ensembles de diodes électroluminescentes formées sur la face avant d'un substrat semiconducteur et isolés électriquement l'un de l'autre. Des connexions verticales traversantes ou TSV (acronyme anglais pour Through Silicon Via) sont réalisées dans le substrat semiconducteur et isolées de ce dernier, chaque TSV reliant la face avant du substrat à la face arrière. Le deuxième circuit intégré comprend des composants électroniques, notamment des transistors, utilisés pour la commande des ensembles de diodes électroluminescentes du premier circuit intégré. Le premier circuit intégré est fixé au deuxième circuit intégré, par exemple par une liaison de type "Flip-Chip". Les billes de soudure qui relient la puce optoélectronique à la puce de commande assurent la liaison mécanique entre la puce optoélectronique et la puce de commande et assurent, en outre, la connexion électrique de chaque ensemble de diodes électroluminescentes à la puce de commande. Le premier circuit intégré est appelé circuit optoélectronique ou puce optoélectronique dans la suite de la description et le deuxième circuit intégré est appelé circuit de commande ou puce de commande dans la suite de la description.

La puce optoélectronique et la puce de commande étant empilées, l'encombrement latéral du dispositif est réduit. A titre d'exemple, le dispositif optoélectronique occupe en vue de dessus une surface comprise entre 1 mm² et quelques centimètres carrés. De plus, la puce optoélectronique peut avoir les mêmes dimensions que la puce de commande. De ce fait, la compacité du dispositif optoélectronique peut, de façon avantageuse, être augmentée.

De préférence, la puce optoélectronique comprend seulement des diodes électroluminescentes et des éléments de connexion de ces diodes électroluminescentes, et la puce de commande comprend la totalité des composants électroniques nécessaires à la commande des diodes électroluminescentes de la puce optoélectronique. A titre de variante, la puce optoélectronique peut également comprendre d'autres composants électroniques en plus des diodes électroluminescentes.

L'ensemble comprenant la puce optoélectronique fixée à la puce de commande peut être disposé dans un boîtier de protection. Le boîtier de protection peut être fixé à un support, par exemple un circuit imprimé, les connexions électriques de la puce de commande à un système externe étant réalisées au travers du boîtier. A titre de variante, la puce de commande, sur laquelle est fixée la puce optoélectronique, peut être fixée directement au support.

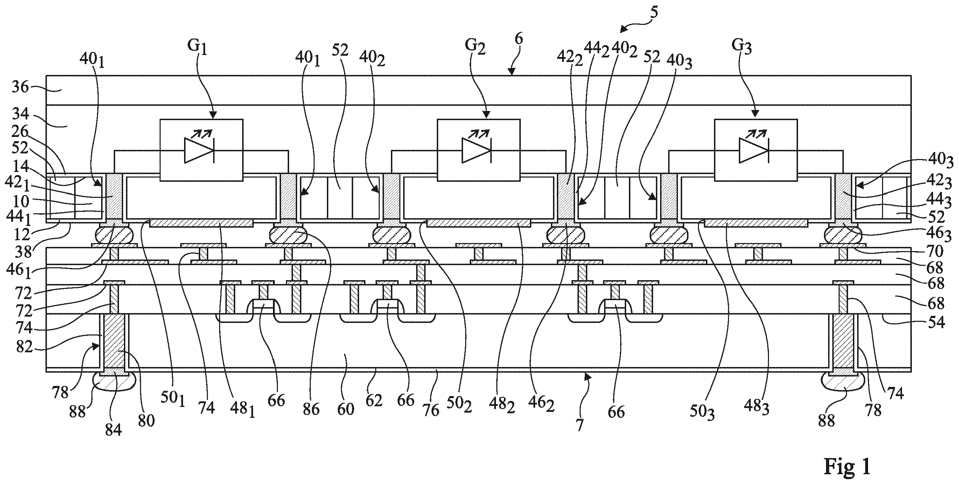

La figure 1 est une vue en coupe, partielle et schématique, d'un mode de réalisation d'un dispositif optoélectronique 5 comprenant une puce optoélectronique 6 fixée à une puce de commande 7, la puce optoélectronique 6 comprenant des diodes électroluminescentes réalisées à partir de fils tels que décrits précédemment. A titre d'exemple, la puce optoélectronique 6 représentée en figure 1 comprend trois groupes G₁, G₂ et G₃ d'ensembles de diodes électroluminescentes. Chaque groupe contient un ou plusieurs ensembles de diodes électroluminescentes, montés en série et/ou en parallèle. Chaque ensemble de diodes comprend une ou plusieurs diodes montées en série et/ou en parallèle. Par connexion de diodes en série, on entend que l'anode d'une diode est connectée à la cathode de l'autre diode. Par connexion de diodes en parallèle, on entend que les anodes des diodes sont connectées ensemble et que les cathodes des diodes sont connectées ensemble. Chaque ensemble de diodes électroluminescentes élémentaires est équivalent à une diode électroluminescente comprenant une anode et une cathode. Par connexion d'ensembles en série, on entend que l'anode d'un ensemble est connectée à la cathode de l'autre ensemble. Par connexion d'ensemble en parallèle, on entend que les anodes des ensembles sont connectées ensemble et que les cathodes des ensembles sont connectées ensemble.

Le nombre de groupes d'ensembles de diodes électroluminescentes dépend de l'application visée et peut varier de 1 à 200.

En figure 1, on a représenté une structure de puce optoélectronique 6 comprenant :
- un substrat semiconducteur 10 comprenant une face inférieure 12 et une face supérieure 14 opposée, la face supérieure 14 étant de préférence plane au moins au niveau des groupes d'ensembles de diodes électroluminescentes ;
- des groupes d'ensembles de diodes électroluminescentes G₁, G₂, G₃, représentés de façon schématique, chaque groupe G₁, G₂, G₃ comprenant deux électrodes, également appelées bornes ;
- une couche isolante 26 s'étendant sur la face 14 du substrat ;
- une couche d'encapsulation 34 recouvrant l'ensemble de la structure et notamment chaque groupe G₁, G₂, G₃ ;
- un support supplémentaire 36, également appelé poignée ;
- une couche isolante 38 recouvrant la face inférieure 12 ;
- pour chaque groupe G₁, G₂, G₃, au moins un TSV 40₁, 40₂, 40₃, deux TSV étant représentés en figure 1, chaque TSV 40₁, 40₂, 40₃ comprenant une portion conductrice 42₁, 42₂, 42₃ qui est connectée à l'une des électrodes du groupe G₁, G₂, G₃, qui s'étend dans le substrat 10 de la face supérieure 14 à la face inférieure 12 et qui est isolée du substrat 10 par une couche isolante 44₁, 44₂, 44₃, la portion conductrice 42₁, 42₂, 42₃ se prolongeant sur la couche isolante 38 par un plot conducteur 46₁, 46₂, 46₃ ;
- des plots conducteurs 48₁, 48₂, 48₃ au contact de la face inférieure 12 au travers d'ouvertures 50₁, 50₂, 50₃ prévues dans la couche isolante 38 ; et
- des moyens 52 d'isolation électrique, pour chaque groupe G₁, G₂, G₃ d'ensembles de diodes électroluminescentes, de la portion 53₁, 53₂, 53₃ du substrat 10 qui s'étend entre la face 12 et la face 14 et entourant les groupes d'ensembles de diodes électroluminescentes G₁, G₂, G₃ associés.

Le dispositif optoélectronique 5 peut, en outre, comprendre une couche de luminophores, non représentée, confondue avec la couche d'encapsulation 34, ou prévue entre la couche d'encapsulation 34 et la poignée 36 ou prévue sur la poignée 36.

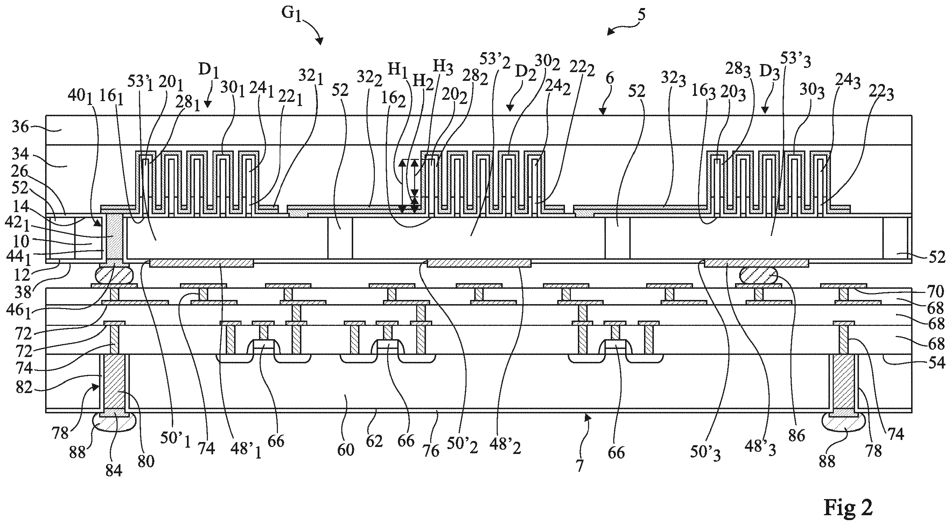

La figure 2 est une vue de détail de la figure 1 d'un mode de réalisation du groupe G₁ d'ensembles de diodes électroluminescentes dans lequel le groupe G₁ comprend trois ensembles D₁, D₂, D₃ de diodes électroluminescentes élémentaires. Les autres groupes G₂ et G₃ peuvent avoir une structure analogue au groupe G₁. Le groupe G₁ comprend :
- des plots de germination 16₁, 16₂, 16₃ favorisant la croissance de fils et disposés sur la face 14 ;
- des fils 20₁, 20₂, 20₃ répartis en au moins deux ensembles de fils (trois ensembles D1, D2, D3, de cinq fils chacun, étant représentés à titre d'exemple en figure 2) de hauteur H₁, chaque fil 20₁, 20₂, 20₃ étant en contact avec l'un des plots de germination 16₁, 16₂, 16₃, chaque fil 20₁, 20₂, 20₃ comprenant une portion inférieure 22₁, 22₂, 22₃ de hauteur H₂, en contact avec le plot de germination 16₁, 16₂, 16₃ et une portion supérieure 24₁, 24₂, 24₃, de hauteur H₃, prolongeant la portion inférieure 22₁, 22₂, 22₃, la couche isolante 26 s'étendant sur les flancs latéraux de la portion inférieure 22₁, 22₂, 22₃ de chaque fil 20₁, 20₂, 20₃ ;
- une coque 28₁, 28₂, 28₃ comprenant un empilement de couches semiconductrices recouvrant chaque portion supérieure 24₁, 24₂, 24₃ ;
- pour chaque ensemble D₁, D₂, D₃, une couche 30₁, 30₂, 30₃ formant une électrode recouvrant chaque coque 28₁, 28₂, 28₃, et les reliant en s'étendant, pour cela, sur la couche isolante 26 ;
- éventuellement, pour chaque ensemble D₁, D₂, D₃, une couche conductrice 32₁, 32₂, 32₃ recouvrant la couche d'électrode 30₁, 30₂, 30₃ entre les fils 20₁, 20₂, 20₃ mais ne s'étendant pas sur les fils 20₁, 20₂, 20₃.

En outre, dans le mode de réalisation représenté en figure 2, le plot conducteur 48₁ se répartit en au moins un plot conducteur 48'₁, 48'₂, 48'₃ par ensemble de fils, au contact de la face inférieure 12 au travers d'ouvertures 50'₁, 50'₂, 50'₃ prévues dans la couche isolante 38, chaque plot conducteur 48'₁, 48'₂, 48'₃ étant sensiblement disposé à l'aplomb des fils 20₁, 20₂, 20₃ de chaque ensemble D₁, D₂, D₃.

En outre, les moyens d'isolation électrique 52 délimitent, pour chaque ensemble D₁, D₂, D₃ de diodes électroluminescentes, la portion 53'₁, 53'₂, 53'₃ du substrat 10 qui s'étend entre les faces 12 et 14 à l'aplomb des fils de l'ensemble D₁, D₂, D₃.

Le fil 20₁, 20₂, 20₃ et la coque 28₁, 28₂, 28₃ associée constituent une diode électroluminescente élémentaire. Dans le mode de réalisation représenté en figure 2, chaque ensemble D₁, D₂, D₃ comprend donc plusieurs diodes électroluminescentes élémentaires connectées en parallèle. Dans le présent mode de réalisation, le support sur lequel reposent les diodes électroluminescentes élémentaires comprend le substrat 10, la couche isolante 38 et les plots de germination 16₁, 16₂, 16₃.

En figure 2, les ensembles D₁, D₂, D₃ de diodes électroluminescentes sont représentés connectés en série. Dans ce but, l'électrode 30₁ de l'ensemble D₁ est connectée à la portion conductrice 42₁ du TSV 40₁. L'électrode 30₂ de l'ensemble D₂ est connectée à la portion 53'₁ de substrat associée à l'ensemble D₁ et l'électrode 30₃ de l'ensemble D₃ est connectée à la portion 53'₂ de substrat associée à l'ensemble D₂.

Sur les figures 1 et 2, on a représenté une structure de puce de commande 7 comprenant :
- un substrat semiconducteur 60 comprenant une face inférieure 62 et une face supérieure 64 opposée ;
- des composants électroniques 66 formés dans et/ou sur le substrat 60, trois transistors MOS étant représentés à titre d'exemple en figure 1 ;
- un empilement de couches isolantes 68 s'étendant sur la face 64 du substrat 60 et sur les composants électroniques 66 et comprenant une face supérieure 69 en vis-à-vis de la puce optoélectronique 5 ;
- des plots conducteurs 70 sur la couche isolante au sommet de l'empilement de couches isolantes 68 ;
- des éléments d'interconnexion, comprenant des pistes conductrices 72 réparties sur les couches isolantes 68 et des vias conducteurs 74 traversant les couches isolantes 68 et reliant les composants électroniques 66 et les plots conducteurs 70 ;
- une couche isolante 76 recouvrant la face inférieure 62 ;
- éventuellement, au moins un TSV 78 traversant le substrat 60 qui permet la connexion en face arrière, le TSV 78 comprenant une portion conductrice 80 qui est connectée à l'un des vias 74 et qui s'étend dans le substrat 60 de la face supérieure 64 à la face inférieure 62 et qui est isolée du substrat 60 par une couche isolante 82, la portion conductrice 80 se prolongeant sur la couche isolante 76 par un plot conducteur 84.

Dans le présent mode de réalisation, la puce optoélectronique 6 est fixée à la puce de commande 7 par des éléments conducteurs fusibles 86, par exemple des billes de soudure ou des billes d'indium. De préférence, au moins certaines billes de soudure 86 relient au moins certains des plots conducteurs 46₁, 46₂, 46₃, 48₁, 48₂, 48₃ de la puce optoélectronique 6 à l'un des plots conducteurs 70 de la puce de commande 7 et assurent une liaison électrique entre ces plots conducteurs.

Dans le mode de réalisation plus détaillé du groupe G₁ représenté en figure 2, un seul TSV 40₁ est associé au groupe G₁ qui est connecté à l'électrode 30₁ de l'ensemble D₁. La connexion entre la puce de commande 7 et l'ensemble D₃ est réalisée par le plot conducteur 48'₃ qui est connecté à la puce de commande 7 par un élément conducteur fusible 86. A titre de variante, dans le cas où deux TSV 40₁ sont associés au groupe G₁, le deuxième TSV 40₁ peut être connecté à la portion de substrat 53'₃ du côté de la face 14.

Selon un mode de réalisation, la mise en série et/ou en parallèle des différents ensembles de diodes électroluminescentes D₁, D₂, D₃ peut être faite par la puce de commande 7. Dans ce cas, chaque ensemble D₁, D₂, D₃ de diodes électroluminescentes a ses deux bornes de connexion reliées à la puce de commande 7 par des billes fusibles 86, l'une par un TSV, l'autre par un plot conducteur 48'₁, 48'₂, 48'₃.

Selon un mode de réalisation, la puce de commande 7 peut être fixée à un circuit externe, par exemple un circuit imprimé, non représenté, par des billes de soudure 88, dont deux sont au contact des plots conducteurs 84.

Dans le présent mode de réalisation, le substrat semiconducteur 10 correspond à une structure monolithique. Le substrat 10 semiconducteur est, par exemple, un substrat en silicium, en germanium, en carbure de silicium, en un composé III-V, tel que du GaN ou du GaAs, ou un substrat en ZnO. De préférence, le substrat 10 est un substrat de silicium monocristallin.

De préférence, le substrat semiconducteur 10 est dopé de façon à baisser la résistivité électrique jusqu'à une résistivité proche de celle des métaux, de préférence inférieure à quelques mohm.cm. Le substrat 10 est de préférence un substrat fortement dopé avec une concentration de dopants comprise entre 5^{∗}10¹⁶ atomes/cm³ et 2^{∗}10²⁰ atomes/cm³, de préférence entre 1^{∗}10¹⁹ atomes/cm³ et 2^{∗}10²⁰ atomes/cm³, par exemple 5^{∗}10¹⁹ atomes/cm³. Le substrat 10 a une épaisseur comprise entre 275 µm et 1500 µm, de préférence 725 µm. Dans le cas d'un substrat 10 de silicium, des exemples de dopants de type P sont le bore (B) ou l'indium (In) et des exemples de dopants de type N sont le phosphore (P), l'arsenic (As), ou l'antimoine (Sb). De préférence, le substrat 10 est dopé de type N au phosphore. La face 12 du substrat 10 de silicium peut être une face (100).

Les plots de germination 16₁, 16₂, 16₃, appelés également îlots de germination, sont en un matériau favorisant la croissance des fils 20₁, 20₂, 20₃. Un traitement peut être prévu pour protéger les flancs latéraux des plots de germination et la surface des parties du substrat non recouvertes par les plots de germination pour empêcher la croissance des fils sur les flancs latéraux des plots de germination et sur la surface des parties du substrat non recouvertes par les plots de germination. Le traitement peut comprendre la formation d'une région diélectrique sur les flancs latéraux des plots de germination et s'étendant sur et/ou dans le substrat et reliant, pour chaque paire de plots, l'un des plots de la paire à l'autre plot de la paire, les fils ne croissant pas sur la région diélectrique. Ladite région diélectrique peut déborder au-dessus des plots de germination 16₁, 16₂, 16₃. A titre de variante, les plots de germination 16₁, 16₂, 16₃ peuvent être remplacés par une couche de germination recouvrant la face 14 du substrat 10 dans la zone associée à chaque ensemble D₁, D₂ ou D₃. Une région diélectrique peut alors être formée au-dessus de la couche de germination pour empêcher la croissance de fils dans les emplacements non voulus.

A titre d'exemple, le matériau composant les plots de germination 16₁, 16₂, 16₃ peut être un nitrure, un carbure ou un borure d'un métal de transition de la colonne IV, V ou VI du tableau périodique des éléments ou une combinaison de ces composés.

La couche isolante 26 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (SiOₓN_{y} où x peut être environ égal à 1/2 et y peut être environ égal à 1, par exemple du Si₂ON₂), en oxyde d'aluminium (Al₂O₃), en oxyde d'hafnium (HfO₂) ou en diamant. A titre d'exemple, l'épaisseur de la couche isolante 26 est comprise entre 5 nm et 800 nm, par exemple égale à environ 30 nm.

Les fils 20₁, 20₂, 20₃ sont, au moins en partie, formés à partir d'au moins un matériau semiconducteur. Le matériau semiconducteur peut être du silicium, du germanium, du carbure de silicium, un composé III-V, un composé II-VI ou une combinaison de ces composés.

Les fils 20₁, 20₂, 20₃ peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils 20₁, 20₂, 20₃ peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Les fils 20₁, 20₂, 20₃ peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn).

La section droite des fils 20₁, 20₂, 20₃ peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil. Le diamètre moyen de chaque fil 20₁, 20₂, 20₃ peut être compris entre 50 nm et 2,5 µm. La hauteur H₁ de chaque fil 20₁, 20₂, 20₃ peut être comprise entre 250 nm et 50 µm. Chaque fil 20₁, 20₂, 20₃ peut avoir une structure semiconductrice allongée selon un axe sensiblement perpendiculaire à la face 14. Chaque fil 20₁, 20₂, 20₃ peut avoir une forme générale cylindrique. Les axes de deux fils 20 adjacents peuvent être distants de 0,5 µm à 10 µm et de préférence de 1,5 µm à 4 µm. A titre d'exemple, les fils 20₁, 20₂, 20₃ peuvent être régulièrement répartis, notamment selon un réseau hexagonal. Le nombre de fils 20₁, 20₂, 20₃ peut varier d'un ensemble D₁, D₂ et D₃ à l'autre.

A titre d'exemple, la portion inférieure 22₁, 22₂, 22₃ de chaque fil 20₁, 20₂, 20₃ est principalement constituée du composé III-N, par exemple du nitrure de gallium, dopé du même type que le substrat 10, par exemple de type N, par exemple au silicium. La portion inférieure 22₁, 22₂, 22₃ s'étend sur une hauteur H₂ qui peut être comprise entre 100 nm et 25 µm.

A titre d'exemple, la portion supérieure 24₁, 24₂, 24₃ de chaque fil 20₁, 20₂, 20₃ est au moins partiellement réalisée dans un composé III-N, par exemple du GaN. La portion supérieure 24₁, 24₂, 24₃ peut être dopée de type N, éventuellement moins fortement dopée que la portion inférieure 22₁, 22₂, 22₃ ou ne pas être intentionnellement dopée. La portion supérieure 24₁, 24₂, 24₃ s'étend sur une hauteur H₃ qui peut être comprise entre 100 nm et 25 µm.

La coque 28₁, 28₂, 28₃ peut comprendre un empilement de plusieurs couches comprenant notamment :
- une couche active recouvrant la portion supérieure 24₁, 24₂, 24₃ du fil 20₁, 20₂, 20₃ associé ;
- une couche intermédiaire de type de conductivité opposé à la portion inférieure 22₁, 22₂, 22₃ et recouvrant la couche active ; et
- une couche de liaison recouvrant la couche intermédiaire et recouverte par l'électrode 30₁, 30₂, 30₃.

La couche active est la couche depuis laquelle est émise la majorité du rayonnement fourni par la diode électroluminescente élémentaire. Selon un exemple, la couche active peut comporter des moyens de confinement des porteurs de charge électrique, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche intermédiaire, par exemple dopée de type P, peut correspondre à une couche semiconductrice ou à un empilement de couches semiconductrices et permet la formation d'une jonction P-N ou P-I-N, la couche active étant comprise entre la couche intermédiaire de type P et la portion supérieure 24₁, 24₂, 24₃ de type N de la jonction P-N ou P-I-N.

La couche de liaison peut correspondre à une couche semiconductrice ou à un empilement de couches semiconductrices et permet la formation d'un contact ohmique entre la couche intermédiaire et l'électrode 30₁, 30₂, 30₃. A titre d'exemple, la couche de liaison peut être dopée très fortement du type opposé à la portion inférieure 22₁, 22₂, 22₃ de chaque fil 20, jusqu'à dégénérer la ou les couches semiconductrices, par exemple dopée de type P à une concentration supérieure ou égale à 10²⁰ atomes/cm³.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

L'électrode 30₁, 30₂, 30₃ est adaptée à polariser la couche active de chaque fil 20₁, 20₂, 20₃ et à laisser passer le rayonnement électromagnétique émis par les diodes électroluminescentes. Le matériau formant l'électrode 30₁, 30₂, 30₃ peut être un matériau transparent et conducteur tel que de l'oxyde d'indium-étain (ou ITO, acronyme anglais pour Indium Tin Oxide), de l'oxyde de zinc dopé à l'aluminium ou au gallium, ou du graphène. A titre d'exemple, la couche d'électrode 30₁, 30₂, 30₃ a une épaisseur comprise entre 5 nm et 200 nm, de préférence entre 20 nm et 50 nm.

La couche conductrice 32₁, 32₂, 32₃ correspond, de préférence à une couche métallique, par exemple en aluminium, en argent, en cuivre ou en zinc. A titre d'exemple, la couche conductrice 32₁, 32₂, 32₃ a une épaisseur comprise entre 20 nm et 1000 nm, de préférence entre 100 nm et 200 nm.

La couche d'encapsulation 34 est réalisée en un matériau isolant au moins partiellement transparent. L'épaisseur minimale de la couche d'encapsulation 34 est comprise entre 250 nm et 50 µm de sorte que la couche d'encapsulation 34 recouvre complètement chaque électrode 30₁, 30₂, 30₃ au sommet des ensembles de diodes électroluminescentes D₁, D₂, D₃. La couche d'encapsulation 34 peut être réalisée en un matériau inorganique au moins partiellement transparent. A titre d'exemple, le matériau inorganique est choisi parmi le groupe comprenant les oxydes de silicium du type SiOₓ où x est un nombre réel compris entre 1 et 2 ou SiO_{y}N_{z} où y et z sont des nombres réels compris entre 0 et 1 et les oxydes d'aluminium, par exemple Al₂O₃. La couche d'encapsulation 34 peut être réalisée en un matériau organique au moins partiellement transparent. A titre d'exemple, la couche d'encapsulation 34 est un polymère silicone, un polymère époxyde, un polymère acrylique ou un polycarbonate.

A titre d'exemple, la poignée 36 a une épaisseur comprise entre 50 µm et 5000 µm, de préférence entre 200 µm et 1000 µm. La poignée 36 est en un matériau au moins en partie transparent. Il peut s'agir de verre, notamment un verre borosilicate, par exemple du pyrex, ou de saphir. Selon un autre mode de réalisation, la poignée 36 n'est pas présente.

La couche active de la coque 28₁, 28₂, 28₃ des diodes électroluminescentes élémentaires d'au moins l'un des ensembles de diodes électroluminescentes D₁, D₂, D₃ est fabriquée de manière non identique à la couche active de la coque des diodes électroluminescentes élémentaires des autres ensembles de diodes électroluminescentes. Ainsi, selon la présente invention, la couche active de la coque 28₁ est adaptée pour émettre une lumière à une première longueur d'onde, par exemple une lumière bleue et la couche active de la coque 28₂ est adaptée pour émettre une lumière à une deuxième longueur d'onde différente de la première longueur d'onde, par exemple une lumière verte. Ceci peut être obtenu, par exemple, en adaptant les épaisseurs ou les compositions des puits quantiques composant ces couches actives. Dans le cadre de la présente invention où les couches actives des coques 28₁, 28₂ sont fabriquées de manières différentes, une première étape de masquage peut être prévue pour protéger l'ensemble D₂ pendant la réalisation de la couche active de la coque 28₁ et une seconde étape de masquage peut être prévue pour protéger l'ensemble D₁ pendant la réalisation de la partie active de la coque 28₂. De plus, l'ensemble D₃ peut être adapté pour émettre une lumière à une troisième longueur d'onde différente des première et deuxième longueurs d'onde, par exemple une lumière rouge. Ainsi la composition des lumières bleue, verte, et rouge peut être choisie pour qu'un observateur perçoive une lumière blanche par composition des couleurs, chaque diode, ou ensemble de diodes, émettant à une première, deuxième et troisième longueur d'onde pouvant être adressée indépendamment des autres afin d'ajuster la couleur.

Dans le mode de réalisation représenté en figure 1, chaque portion conductrice 42₁, 42₂, 42₃ peut correspondre à une couche ou à un empilement de couches recouvrant la couche isolante 44₁, 44₂, 44₃. Le coeur du TSV 40₁, 40₂, 40₃ peut être rempli en totalité ou seulement partiellement d'un matériau conducteur.

Dans le mode de réalisation décrit précédemment, les TSV 40₁, 40₂, 40₃ viennent au contact de l'électrode 30₁, 30₂, 30₃ à la périphérie de chaque ensemble D₁, D₂, D₃ de diodes électroluminescentes. Selon un autre mode de réalisation, un TSV peut, de plus, être prévu au niveau de chaque fil 20₁, 20₂, 20₃ de la puce optoélectronique 6. Chaque TSV vient au contact du plot de germination 16₁, 16₂, 16₃ du fil associé. Les TSV peuvent ne pas être connectés les uns aux autres. Les fils peuvent alors être polarisés séparément. A titre de variante, une électrode prévue du côté de la face arrière 12 du substrat 10, peut être connectée à l'ensemble des TSV associées à un même ensemble D₁, D₂, D₃ de diodes électroluminescentes. Selon un autre mode de réalisation, un TSV peut venir au contact simultanément des plots de germination 16₁, 16₂, 16₃ de plusieurs fils 20₁, 20₂, 20₃ d'un même ensemble D₁, D₂, D₃ de diodes électroluminescentes.

Selon un autre mode de réalisation, chaque TSV 40₁, 40₂, 40₃ peut être formé par un matériau de remplissage, par exemple du silicium polycristallin, du tungstène ou un matériau métallique réfractaire qui supporte le budget thermique durant les étapes ultérieures du procédé de fabrication de la puce optoélectronique 6. Le silicium polycristallin a, de façon avantageuse, un coefficient de dilatation thermique proche du silicium et permet ainsi de réduire les contraintes mécaniques durant les étapes ultérieures réalisées à températures élevées du procédé de fabrication de la puce optoélectronique 6.

Selon un autre mode de réalisation, au lieu de former un TSV avec un matériau de remplissage isolé du substrat 10 par des parois isolantes, le TSV peut être réalisé par des tranchées d'isolation délimitant une portion du substrat qui joue alors le rôle de la portion conductrice du TSV. De préférence, on utilise alors du silicium fortement dopé, par exemple ayant une concentration de dopants supérieure ou égale à 10¹⁹ atomes/cm³, pour diminuer la résistance de cette connexion.

Dans le présent mode de réalisation, les moyens d'isolation électrique 52 comprennent des tranchées s'étendant sur toute l'épaisseur du substrat 10 et remplies d'un matériau isolant, par exemple un oxyde, notamment de l'oxyde de silicium, ou un polymère isolant. A titre de variante, l'isolation électrique de chaque portion de substrat 10 associée à chaque diode est réalisée par le TSV 40₁. Selon une autre variante, les murs d'isolation électrique 52 comprennent des régions dopées d'un type de polarité opposé au substrat 10 et s'étendant sur toute la profondeur du substrat 10.

Selon un autre mode de réalisation, le substrat 10 peut ne pas être présent. Une couche miroir peut alors être disposée sur la face inférieure de la puce optoélectronique au contact des plots de germination 16₁, 16₂, 16₃. Selon un mode de réalisation, la couche miroir est adaptée à réfléchir au moins en partie le rayonnement émis par les diodes électroluminescentes élémentaires. La couche miroir peut être recouverte d'au moins une couche métallique. La couche isolante 38 recouvre alors directement la couche miroir (ou la couche métallique si elle est présente). Les plots conducteurs 46₁, 46₂, 46₃, 48₁, 48₂, 48₃ sont formés sur la couche isolante 38 comme cela a été décrit précédemment.

Dans ce mode de réalisation, le support sur lequel reposent les diodes électroluminescentes élémentaires comprend les plots de germination, la couche miroir et les plots conducteurs.

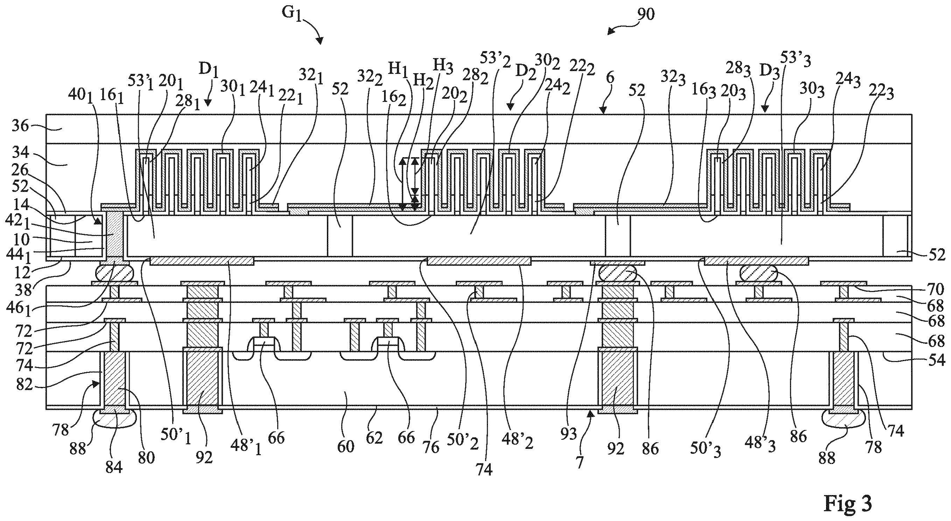

La figure 3 représente un autre mode de réalisation d'un dispositif optoélectronique 90 comprenant l'ensemble des éléments du dispositif optoélectronique 5 et dans lequel la puce de commande 7 comprend, en outre, des drains thermiques 92, deux drains thermiques 92 étant représentés à titre d'exemple en figure 3. Les drains thermiques 92 permettent, de façon avantageuse, d'améliorer l'évacuation de la chaleur produite par la puce optoélectronique 6 en fonctionnement. De préférence, chaque drain thermique 92 s'étend sur la totalité de l'épaisseur de la puce de commande 7. Chaque drain thermique 92 est constitué d'un empilement de matériaux bons conducteurs de la chaleur. De préférence, la portion du drain thermique 92 qui s'étend dans le substrat 60 est isolée électriquement du substrat 60 et peut avoir une structure analogue à un TSV telle que décrite précédemment. Selon un exemple, le drain thermique 92 peut ne pas être connecté à la puce optoélectronique. C'est le cas du drain thermique 92 représenté à gauche en figure 3. Selon un autre exemple, le drain thermique 92 peut être connecté, par une bille de soudure 86, à un plot conducteur 93, comme cela est le cas du drain thermique 92 représenté à droite en figure 3, disposé sur une zone du substrat de la puce optoélectronique isolée des zones électriquement actives soit parce qu'elle est constituée d'une zone du substrat entièrement isolée du reste du substrat par des tranchées remplies d'isolant électrique, soit parce qu'elle est constituée d'une zone du substrat recouverte par une couche isolante électriquement.

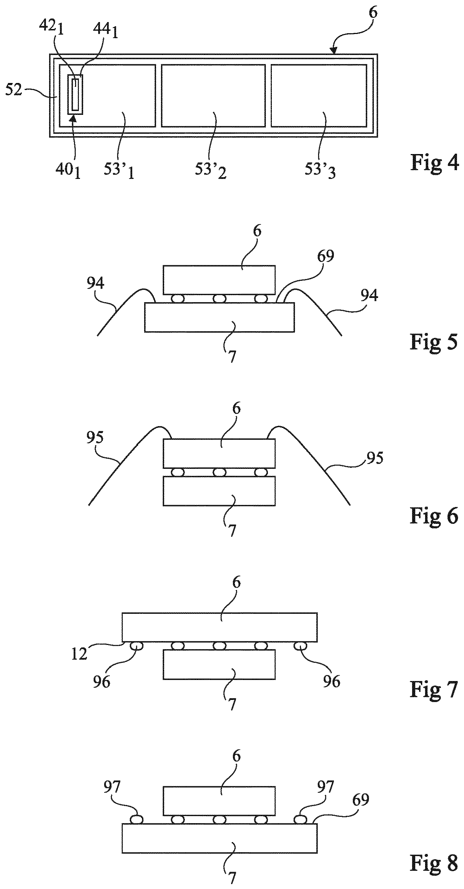

La figure 4 est une coupe de la figure 2 selon la ligne IV-IV. Sur cette figure, les murs d'isolation électrique 52 sont représentés entourant complètement la portion du substrat 10 associée à chaque ensemble de diodes électroluminescentes D₁, D₂, D₃. Toutefois, à titre de variante, pour chaque paire d'ensembles de diodes électroluminescentes, un mur d'isolation électrique 52 peut être prévu seulement entre les deux ensembles adjacents sur la totalité de la largeur de la puce optoélectronique 6. A titre d'exemple, dans le plan de coupe de la figure 4, chaque mur d'isolation électrique peut avoir une largeur comprise entre 200 nm et 250 µm et préférentiellement entre 5 µm et 30 µm.

Dans le mode de réalisation décrit précédemment, la couche isolante 26 recouvre la totalité du pourtour de la portion inférieure 22₁, 22₂, 22₃ de chaque fil 20₁, 20₂, 20₃. A titre de variante, une partie de la portion inférieure 22₁, 22₂, 22₃, voire la totalité de la portion inférieure 22₁, 22₂, 22₃, peut ne pas être recouverte par la couche isolante 26. Dans ce cas, la coque 28₁, 28₂, 28₃ peut recouvrir chaque fil 20 sur une hauteur supérieure à H₃, voire sur la hauteur H₁. En outre, dans le mode de réalisation décrit précédemment, la couche isolante 26 ne recouvre pas le pourtour de la portion supérieure 24₁, 24₂, 24₃ de chaque fil 20₁, 20₂, 20₃. A titre de variante, la couche isolante 26 peut recouvrir une partie de la portion supérieure 24₁, 24₂, 24₃ de chaque fil 20₁, 20₂, 20₃. De plus, selon une autre variante, la couche isolante 26 peut, pour chaque fil 20₁, 20₂, 20₃, recouvrir partiellement la portion inférieure de la coque 28₁, 28₂, 28₃.

Dans les modes de réalisation représentés sur les figures 1, 2 et 3, le dispositif optoélectronique 5 est relié électriquement à un circuit externe par les billes de soudure 88 prévus sur la face inférieure de la puce de commande 7. Toutefois, d'autres modes de connexion électrique peuvent être envisagés.

La figure 5 représente un autre mode de réalisation dans lequel la puce de commande 7 est reliée électriquement à un circuit externe, par exemple un circuit imprimé, non représenté, par des fils 94 qui sont connectés à la face supérieure 69 de la puce de commande 7 sur laquelle est fixée la puce optoélectronique 6.

La figure 6 représente un autre mode de réalisation dans lequel la puce optoélectronique 6 est reliée électriquement à un circuit externe, par exemple un circuit imprimé, non représenté, par des fils 95 qui sont connectés du côté de la face supérieure de la puce optoélectronique 6 à des plots conducteurs.

La figure 7 représente un autre mode de réalisation dans lequel la puce optoélectronique 6 est reliée électriquement à un circuit externe, par exemple un circuit imprimé, non représenté, par des billes de soudure 96 qui sont connectées du côté de la face inférieure 12 de la puce optoélectronique 6.

La figure 8 représente un autre mode de réalisation dans lequel la puce optoélectronique 6 est reliée électriquement à un circuit externe, par exemple un circuit imprimé, non représenté, par des billes de soudure 97 qui sont connectées à la face supérieure 69 de la puce de commande 7.

Les modes de réalisation représentés sur les figures 5 à 8 permettent avantageusement de fixer la face arrière de la puce de commande 7 à un support conducteur thermiquement auquel peuvent être reliés les drains thermiques 92. Ceci améliore l'évacuation de la chaleur produite dans la puce de commande 7.

Selon un mode de réalisation, le procédé de fabrication du dispositif optoélectronique 5 comprend les étapes suivantes :
- fabrication de la puce optoélectronique 6 ;
- fabrication de la puce de commande 7 ;
- assemblage de la puce optoélectronique 6 avec la puce de commande 7 ;
- éventuellement, mise en place de l'empilement de la puce de commande 7 et de la puce optoélectronique 6 dans un boîtier de protection ; et
- fixation de l'empilement de la puce de commande 7 et de la puce optoélectronique 6 sur un support.

Un mode de réalisation d'un procédé de fabrication des ensembles de diodes électroluminescentes D₁, D₂, D₃ est décrit dans les demandes de brevet WO 2014/044960 A1 et FR 3 011 383 A1 (numéro d'enregistrement national: FR13/59413)

Un mode de réalisation des TSV 42₁ du groupe de diodes électroluminescentes G₁, selon le mode de réalisation représenté en figure 2, comprend les étapes suivantes, les TSV 42₂, 42₃ pouvant être réalisés simultanément de la même façon :
(1) Gravure d'au moins une ouverture traversant la couche isolante 38, le substrat 10, la couche isolante 26 pour exposer la couche d'électrode 30₁. Cette ouverture peut avoir une section droite circulaire ou rectangulaire. De préférence, la couche d'électrode 30₁ est également gravée pour exposer une portion de la couche métallique 32₁. La gravure du substrat 10 peut être une gravure ionique réactive profonde (DRIE, acronyme anglais pour Deep Reactive Ion Etching). La gravure de la portion de la couche isolante 26 est aussi réalisée par gravure plasma avec la chimie adaptée à la couche isolante 26. En même temps, on peut graver la couche d'électrode 30₁. A titre de variante, la couche 30₁ peut être retirée des zones de formation des TSV avant l'étape de formation de la couche métallique 32₁. Des tranchées pour la réalisation des murs d'isolation électrique 52 peuvent être réalisées simultanément aux ouvertures prévues pour les TSV.
(2) Formation de la couche isolante 44₁ par exemple en SiO₂ ou SiON sur la couche 38 et sur les parois internes de l'ouverture gravée à l'étape (1). La couche isolante 44₁ est, par exemple, réalisée par dépôt conforme par PECVD (acronyme anglais pour Plasma Enhanced Chemical Vapor Déposition) ou par dépôt conforme d'un polymère isolant. La couche isolante 44₁ a une épaisseur comprise entre 200 nm et 5000 nm, par exemple d'environ 3 µm. La couche isolante 44₁ peut être formée en même temps que les murs d'isolation électrique 52.
(3) Gravure de la couche isolante 44₁ pour exposer la couche conductrice 32₁ au fond de l'ouverture gravée à l'étape (2). Il s'agit d'une gravure anisotrope.
(4) Gravure d'au moins une ouverture 50₁ dans la couche isolante 38 pour exposer une portion de la face 12 du substrat 10. Pour réaliser cette gravure, l'ouverture gravée à l'étape (1) peut être temporairement bouchée, par exemple par une résine.
(5) Remplissage des TSV et formation des plots conducteurs 46₁, 48'₁, 48'₂, 48'₃. Le remplissage des TSV peut être réalisé par dépôt électrolytique de cuivre. Le dépôt est alors planarisé avec une étape de polissage mécano-chimique (CMP). Ensuite, un dépôt métallique peut reprendre le contact sur les plots pour le reporter sur la face 12 du substrat 10.

A titre de variante, les TSV 40₁ peuvent être réalisés du côté de la face supérieure 14 du substrat 10, par exemple avant la formation des coques 28₁, 28₂, 28₃. Les TSV 40₁ ne sont alors réalisés que sur une partie de l'épaisseur du substrat 10 et sont exposés du côté de la face inférieure 12 du substrat 10 après une étape d'amincissement du substrat 12. Le remplissage des TSV peut alors être réalisé par dépôt chimique en phase vapeur (CVD, sigle anglais pour Chemical Vapor Déposition) et l'isolation des TSV peut se faire par oxydation thermique.

Le procédé de fabrication de la puce de commande 7 peut comprendre les étapes classiques d'un procédé de fabrication d'un circuit intégré et n'est pas décrit plus en détail.

Les méthodes d'assemblage de la puce optoélectronique 6 sur la puce de commande 7 peuvent comprendre des opérations de brasage. L'empilement métallique formant les plots conducteurs 46₁, 46₂, 46₃, 48₁, 48₂, 48₃, 70 est choisi de manière à être compatible avec les opérations de brasage utilisées dans l'industrie de l'électronique et notamment avec la brasure utilisée, par exemple en Cu avec finition OSP (acronyme anglais pour Organic Solderability Preservative) ou finition Ni-Au (par voie chimique, notamment pour obtenir une structure de type ENIG, acronyme anglais pour Electroless Nickel Immersion Gold, ou par voie électrochimique), Sn, Sn-Ag, Ni-Pd-Au, Sn-Ag-Cu, Ti-Wn-Au ou ENEPIG (acronyme anglais pour Electroless Nickel/ Electroless Palladium/ Immersion Gold).

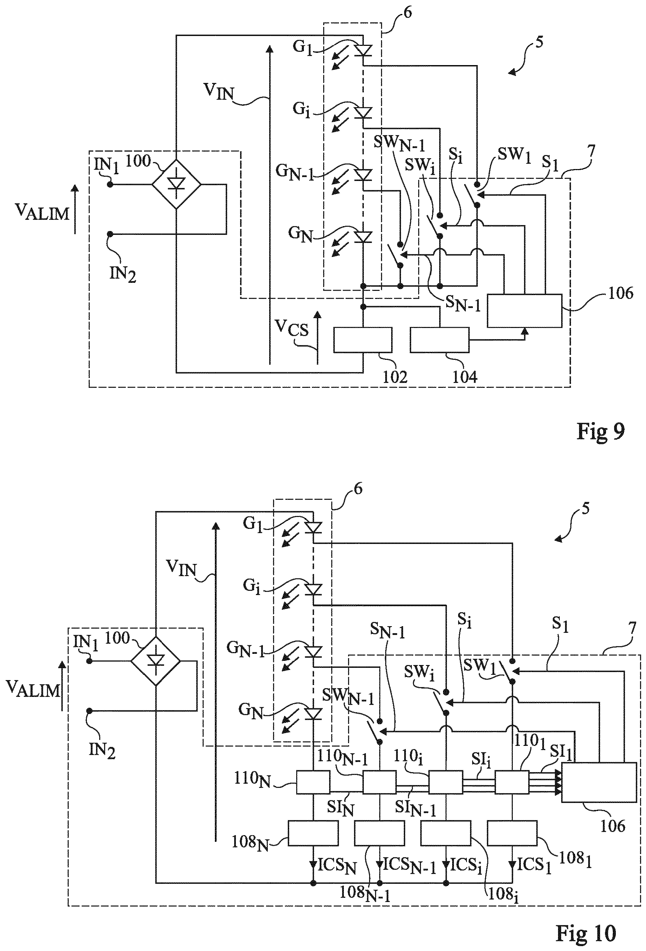

La figure 9 représente un schéma électrique équivalent d'un mode de réalisation du dispositif optoélectronique 5 dans lequel la puce de commande 7 est adaptée pour commander les groupes de diodes électroluminescentes de la puce optoélectronique 6 à partir d'une tension d'alimentation alternative. Toutefois, il est clair que le schéma électrique représenté en figure 9 n'est qu'un mode de réalisation et que les fonctions réalisées par la puce de commande 7 sont à adapter en fonction de l'utilisation prévue du dispositif optoélectronique 5.

Dans ce mode de réalisation, la puce de commande 7 comprend deux bornes d'entrée IN₁ et IN₂ destinées à recevoir une tension d'alimentation V_{ALIM}. A titre d'exemple, la tension d'entrée V_{ALIM} peut être une tension sinusoïdale dont la fréquence est, par exemple, comprise entre 10 Hz et 1 MHz. La tension V_{ALIM} correspond, par exemple, à la tension du secteur.

La puce de commande 7 comprend un circuit redresseur double alternance 100 comprenant, par exemple, un pont de diodes formé par exemple de quatre diodes. Le circuit redresseur 100 reçoit la tension d'alimentation V_{ALIM} et fournit une tension V_{IN}.

La puce optoélectronique 6 comprend N groupes de diodes électroluminescentes Gᵢ, i variant de 1 à N, où N est un nombre entier compris entre 2 et 200, de préférence entre 2 et 20.

Dans le présent mode de réalisation, les N groupes de diodes électroluminescentes Gᵢ, sont connectés en série. Chaque groupe Gᵢ peut comprendre plusieurs ensembles de diodes électroluminescentes, par exemple connectés en série. La connexion en série peut être réalisée directement au niveau de la puce optoélectronique 6. A titre d'exemple, chaque plot conducteur 48ᵢ d'un groupe de diodes électroluminescentes Gᵢ se prolonge pour venir en contact avec le plot conducteur 46ᵢ₊₁ du groupe de diodes électroluminescentes Gᵢ₊₁ voisin. A titre de variante, la mise en série des groupes de diodes électroluminescentes peut être réalisée par des éléments de connexion situés dans la puce de commande 7.

La puce de commande 7 comprend une source de courant 102 montée en série avec les groupes de diodes électroluminescentes G₁ à G_{N}. La cathode du dernier ensemble de diodes électroluminescentes du groupe Gᵢ est reliée à l'anode du premier ensemble de diodes électroluminescentes du groupe Gᵢ₊₁, pour i variant de 1 à N-1. La puce de commande 7 comprend, en outre, N-1 interrupteurs commandables SW₁ à SW_{N-1}. Chaque interrupteur SWᵢ, i variant de 1 à N-1, est monté en parallèle entre la cathode du dernier ensemble de diodes électroluminescentes du groupe Gᵢ et l'anode du premier ensemble de diodes électroluminescentes du groupe Gᵢ₊₁. Chaque interrupteur SWᵢ, i variant de 1 à N-1, est commandé par un signal Sᵢ.

La puce de commande 7 comprend, en outre, un capteur 104 de tension adapté à fournir un signal S_{V} représentatif de la tension V_{CS} aux bornes de la source de courant 102. La puce de commande 7 comprend, en outre, un module de commande 106 recevant le signal S_{V} et fournissant les signaux S₁ à S_{N-1} de commande de la fermeture ou l'ouverture des interrupteurs SW₁ à SW_{N-1}. Le module de commande 106 correspond, de préférence, à un circuit dédié.

Le fonctionnement du dispositif optoélectronique 5 selon le mode de réalisation représenté en figure 8 est le suivant en considérant que les interrupteurs sont parfaits. Le module de commande 106 est adapté à commander la fermeture ou l'ouverture des interrupteurs SWᵢ, i variant de 1 à N-1, en fonction de la valeur de la tension V_{CS} aux bornes de la source de courant 102. Dans ce but, le module de commande 106 est adapté à comparer la tension V_{CS} à au moins un seuil. A titre d'exemple, la tension V_{IN} fournie par le pont redresseur 100 est une tension sinusoïdale rectifiée comprenant une succession de cycles dans chacun desquels la tension V_{IN} augmente depuis la valeur nulle, passe par un maximum et diminue jusqu'à la valeur nulle. Au début de chaque cycle, tous les interrupteurs SWᵢ, i variant de 1 à N-1, sont fermés. De ce fait, les groupes de diodes électroluminescentes G₂ à G_{N} sont court-circuités et la tension V_{IN} se répartit entre le groupe de diodes électroluminescentes G₁ et la source de courant 102. La tension V_{IN} s'élève depuis la valeur nulle. Lorsque la tension aux bornes du groupe de diodes électroluminescentes G₁ dépasse sa tension de seuil, le groupe de diodes électroluminescentes G₁ devient passant et commence à émettre de la lumière. La tension aux bornes du groupe G₁ de diodes électroluminescentes est alors sensiblement fixe et la tension V_{CS} continue à augmenter avec la tension V_{IN}. Lorsque la tension V_{CS} dépasse un seuil, le module 106 commande l'ouverture de l'interrupteur SW₁. La tension V_{IN} se répartit alors entre les groupes G₁ et G₂ de diodes électroluminescentes et la source de courant 102. Lorsque la tension aux bornes du groupe G₂ de diodes électroluminescentes dépasse sa tension de seuil, le groupe G₂ de diodes électroluminescentes devient passant et commence à émettre de la lumière. La tension aux bornes du groupe G₂ de diodes électroluminescentes est alors sensiblement fixe et la tension V_{CS} continue à augmenter avec la tension V_{IN}. Lorsque la tension V_{CS} dépasse un seuil, le module 106 commande l'ouverture de l'interrupteur SW₂. Ces étapes sont répétées jusqu'à ce que l'interrupteur SW_{N-1} soit ouvert. Toutes les diodes électroluminescentes sont alors passantes. Lorsque la tension V_{IN} décroît depuis son maximum, les interrupteurs SW_{N-1} à SW₁ sont successivement fermés dans cet ordre au fur et à mesure que la tension V_{IN} décroît, par exemple chaque fois que la tension V_{CS} passe en dessous d'un seuil.

A titre de variante, lorsque les interrupteurs SW₁ à SW_{N-1} sont réalisés par des transistors à effet de champ à grille métal-oxyde ou transistors MOS, au lieu de mesurer la tension V_{CS}, il peut être souhaitable de mesurer les tensions aux bornes des transistors.

La figure 10 représente un autre mode de réalisation de la puce de commande 7. Dans ce mode de réalisation, la puce de commande 7 comprend une source de courant commandable 108ᵢ, i variant de 1 à N, associée à chaque groupe de diodes électroluminescentes Gᵢ. Le module de commande 106 est adapté à activer ou désactiver indépendamment chaque source de courant 108ᵢ. Les sources de courant 108ᵢ, i variant de 1 à N, ont une borne commune. A chaque source de courant 108ᵢ, i variant de 1 à N, est associé un capteur 110ᵢ fournissant au module de commande 106 un signal SIᵢ représentatif de la tension aux bornes de la source de courant 108ᵢ. La source de courant 108_{N} a une borne reliée à la cathode du dernier ensemble de diodes électroluminescentes du groupe G_{N}. Chaque source de courant 108ᵢ, i variant de 2 à N, a une borne reliée à la cathode du dernier ensemble de diodes électroluminescentes du groupe Gᵢ.

Le fonctionnement du dispositif optoélectronique 5 selon le mode de réalisation représenté en figure 9 est le suivant. Le module de commande 106 est adapté à activer successivement chaque source de courant 108ᵢ, i variant de 1 à N-1, tout en désactivant la source de courant précédemment activée, en fonction de la tension aux bornes de chaque source de courant 102ᵢ, i variant de 1 à N.

Divers modes de réalisation avec diverses variantes ont été décrits ci-dessus. On notera que l'homme de l'art pourra combiner divers éléments de ces divers modes de réalisation et variantes sans faire preuve d'activité inventive. A titre d'exemple, le schéma électrique du dispositif optoélectronique 5 représenté en figure 9 ou 10 peut être mis en oeuvre avec la structure du dispositif 5 représentée en figure 2 ou du dispositif 90 représentée en figure 3. La présente invention est définie par les revendications qui suivent.

## Revendications

1. Dispositif optoélectronique (5 ; 90) comprenant :
un premier circuit intégré (6) comprenant un support comprenant des première et deuxième faces opposées, des groupes (G₁, G₂, G₃) d'ensembles (D₁, D₂, D₃) de diodes électroluminescentes reposant sur la première face dont des premier et deuxième ensembles (D₁, D₂) chaque groupe comprenant au moins un ensemble de diodes électroluminescentes connectées en parallèle entre des première et deuxième bornes, chaque ensemble (D₁, D₂, D₃) de diodes électroluminescentes comprenant un élément semiconducteur (20₁, 20₂, 20₃) filaire ou plusieurs éléments semiconducteurs filaires connectés en parallèle, le premier ensemble (D₁) étant adapté à émettre une lumière à une première longueur d'onde et le deuxième ensemble (D₂) étant adapté à émettre une lumière à une deuxième longueur d'onde différente de la première longueur d'onde, le premier circuit intégré comprenant, en outre, dans le support, des premiers éléments (52) d'isolation électrique latérale de portions du support autour de chaque ensemble, et, sur la deuxième face, pour chaque groupe, au moins un premier plot conducteur (46₁, 46₂, 46₃) relié à la première borne du groupe et un deuxième plot conducteur (48₁, 48₂, 48₃) relié à la deuxième borne du groupe ; et
un deuxième circuit intégré (7) comprenant des troisième et quatrième faces opposées, des troisièmes plots conducteurs (70) sur la troisième face reliés électriquement aux premiers et deuxièmes plots conducteurs,
le premier circuit intégré étant fixé sur la troisième face du deuxième circuit intégré.

2. Dispositif optoélectronique selon la revendication 1, dans lequel le support comprend un substrat (10) comprenant des cinquième et sixième faces opposées (14, 12), les diodes électroluminescentes étant situées du côté de la cinquième face (14), et comprenant, pour chaque ensemble (D₁, D₂, D₃), au moins un deuxième élément (40₁, 40₂, 40₃) conducteur isolé du substrat et traversant le substrat depuis la cinquième face jusqu'à la sixième face (12) et connecté à l'un des premiers plots conducteurs.

3. Dispositif optoélectronique selon la revendication 2, dans lequel les premiers éléments (52) sont adaptés à isoler électriquement latéralement des portions (53₁, 53₂, 53₃) du substrat (10) sous-jacentes aux diodes électroluminescentes de chaque ensemble (D₁, D₂, D₃).

4. Dispositif optoélectronique selon la revendication 3, dans lequel les premiers éléments (52) comprennent des murs isolants s'étendant dans le substrat depuis la cinquième face jusqu'à la sixième face.

5. Dispositif optoélectronique selon l'une quelconque des revendications 1 à 4, dans lequel le deuxième circuit intégré (7) comprend des drains thermiques (92) traversant le deuxième circuit intégré depuis la troisième face jusqu'à la quatrième face.

6. Dispositif optoélectronique selon l'une quelconque des revendications 1 à 5, comprenant, pour chaque ensemble (D₁, D₂, D₃), une couche d'électrode (30₁, 30₂, 30₃) recouvrant chaque diode électroluminescente dudit ensemble et comprenant, en outre, une couche conductrice (32₁, 32₂, 32₃) recouvrant la couche d'électrode autour des diodes électroluminescentes dudit ensemble.

7. Dispositif optoélectronique selon les revendications 2 et 6, dans lequel le deuxième élément (40₁, 40₂, 40₃) est en contact avec la couche conductrice (32₁, 32₂, 32₃) ou la couche d'électrode (30₁, 30₂, 30₃).

8. Dispositif optoélectronique selon l'une quelconque des revendications 1 à 7, dans lequel le deuxième circuit intégré (7) comprend un circuit redresseur (100) destiné à recevoir une tension alternative (V_{ALIM}).

9. Dispositif optoélectronique selon l'une quelconque des revendications 1 à 8, dans lequel le premier circuit intégré (6) comprend N groupes (G₁, Gᵢ, G_{N}) d'ensembles de diodes électroluminescentes, où N est un nombre entier variant de 2 à 200, et dans lequel le deuxième circuit intégré (7) comprend N-1 interrupteurs (SW₁, SWᵢ, SW_{N-1}), chaque interrupteur étant relié à la première borne ou la deuxième borne d'un desdits groupes.

10. Dispositif optoélectronique selon la revendication 9, dans lequel le deuxième circuit intégré (7) comprend N sources de courant (108₁, 108ᵢ, 108_{N}), chacune de N-1 desdites sources de courant étant reliée à la première ou deuxième borne d'un desdits groupes (G₁, Gᵢ, G_{N}).

11. Dispositif optoélectronique selon l'une quelconque des revendications 1 à 10, comprenant des quatrièmes plots conducteurs (84) sur la quatrième face.

12. Dispositif optoélectronique selon l'une quelconque des revendications 1 à 11, comprenant en outre un troisième ensemble (D₃) de diodes électroluminescentes adapté à émettre une lumière à une troisième longueur d'onde différente de la première longueur d'onde et de la deuxième longueur d'onde.

## Patentansprüche

1. Ein optoelektronisches Bauelement (5; 90) das Folgendes aufweist:
einen ersten integrierten Schaltkreis (6), aufweisend einen Träger, der erste und zweite entgegengesetzte Oberflächen aufweist, Gruppen (G₁, G₂, G₃) von Anordnungen (D₁, D₂, D₃) von lichtemittierenden Dioden die auf der ersten Oberfläche ruhen, darunter erste und zweite Anordnungen (D₁, D₂), wobei jede Gruppe wenigstens eine Anordnung von lichtemittierenden Dioden aufweist, die parallel zwischen ersten und zweiten Anschlüssen verbunden sind, wobei jede Anordnung (D₁, D₂, D₃) von lichtemittierenden Dioden ein Draht-Halbleiterelement (20₁, 20₂, 20₃) oder eine Vielzahl von parallelen Draht-Halbleiterelementen oder mehrere Draht-Halbleiterelemente aufweist, wobei die erste Anordnung (D₁) angepasst ist Licht bei einer ersten Wellenlänge zu emittieren und die zweite Anordnung (D₂) angepasst ist Licht bei einer zweiten Wellenlänge zu emittieren, die verschieden von der ersten Wellenlänge ist, wobei der erste integrierte Schaltkreis ferner, in dem Träger, erste Elemente (52) von lateraler elektrischer Isolierung von Abschnitten der Träger um jede Anordnung herum aufweist und, auf der zweiten Oberfläche, für jede Gruppe, wenigstens ein leitendes Pad (46₁, 46₂, 46₃), das mit dem ersten Anschluss der Gruppe verbunden ist, und eine zweites leitendes Pad (48₁, 48₂, 48₃), das mit dem zweiten Anschluss der Gruppe verbunden ist; und
einen zweiten integrierten Schaltkreis (7) aufweisend dritte und vierte entgegengesetzte Oberflächen, dritte leitende Pads (70) auf der dritten Oberfläche, elektrisch verbunden mit den ersten und zweiten leitenden Pads,
wobei der erste integrierte Schaltkreis an der dritten Oberfläche des zweiten integrierten Schaltkreises angebracht ist.

2. Das optoelektronische Bauelement nach Anspruch 1, wobei der Träger ein Substrat (10) mit fünften und sechsten entgegengesetzte Oberflächen (14, 12) aufweist, wobei die lichtemittierenden Dioden auf der Seite der fünften Oberfläche (14) angebracht sind und, für jede Anordnung (D₁, D₂, D₃), wenigstens ein leitendes Element (40₁, 40₂, 40₃) isoliert von dem Substrat und das Substrat durchquerend von der fünften Oberfläche zu der sechste Oberfläche (12) und verbunden mit dem einen der ersten leitenden Pads, aufweist.

3. Das optoelektronische Bauelement nach Anspruch 2, wobei die ersten Elemente (52) in der Lage sind lateral elektrisch Abschnitte (53₁, 53₂, 53₃) des Substrats (10) zu isolieren, welches unter den lichtemittierenden Dioden jeder Anordnung (D₁, D₂, D₃) liegt.

4. Das optoelektronische Bauelement nach Anspruch 3, wobei die ersten Elemente (52) isolierende Wände aufweisen, die sich im Substrat von der fünften Oberfläche zu der sechsten Oberfläche erstrecken.

5. Das optoelektronische Bauelement nach einem der Ansprüche 1 bis 4, wobei der zweite integrierte Schaltkreis (7) thermische Senken (92) aufweist, die den zweiten integrierten Schaltkreis von der dritten Oberfläche zu der vierten Oberfläche durchqueren.

6. Das optoelektronische Bauelement nach einem der Ansprüche 1 bis 5, aufweisend, für jede Anordnung (D₁, D₂, D₃), eine Elektrodenschicht (30₁, 30₂, 30₃), die jede lichtemittierende Diode der Anordnung abdeckt und ferner aufweisend eine leitende Schicht (32₁, 32₂, 32₃), die die Elektrodenschicht um die lichtemittierenden Dioden der Anordnung herum abdeckt.

7. Das optoelektronische Bauelement nach Anspruch 2 und 6, wobei das zweite Element (40₁, 40₂, 40₃) in Kontakt mit einer leitenden Schicht (32₁, 32₂, 32₃) oder einer Elektrodenschicht (30₁, 30₂, 30₃) steht.

8. Das optoelektronische Bauelement nach einem der Ansprüche 1 bis 7, wobei der zweite integrierte Schaltkreis (7) einen Richtschaltkreis (100) aufweist um eine AC Spannung (VALIM) zu empfangen.

9. Das optoelektronische Bauelement nach einem der Ansprüche 1 bis 8, wobei der erste integrierte Schaltkreis (6) N Gruppen (G₁, G₂, G₃) von Anordnungen von lichtemittierenden Dioden aufweist, wobei N eine ganze Zahl zwischen 2 bis 200 ist, und wobei der zweite integrierte Schaltkreis (7) N-1 Schalter (SW₁,SWᵢ,SW_{N-1}) aufweist, wobei jeder Schalter mit dem ersten Anschluss oder dem zweiten Anschluss einer der genannten Gruppen verbunden ist.

10. Das optoelektronische Bauelement nach Anspruch 9, wobei der zweite integrierte Schaltkreis (7) N Stromquellen (108₁, 108ᵢ, 108_{N}) aufweist, wobei jede von N-1 der Stromquellen mit dem ersten oder dem zweiten Anschluss einer der genannten Gruppen verbunden ist.

11. Das optoelektronische Bauelement nach einem der Ansprüche 1 bis 10, aufweisend vierte leitende Pads (84) auf der vierten Oberfläche.

12. Das optoelektronische Bauelement nach einem der Ansprüche 1 bis 11, ferner aufweisend eine dritte Anordnung (D₃) von lichtemittierenden Dioden angepasst Licht bei einer dritten Wellenlänge zu emittieren verschieden von der ersten Wellenlänge und der zweiten Wellenlänge.

## Claims

1. An optoelectronic device (5; 90) comprising:
a first integrated circuit (6) comprising a support comprising first and second opposite surfaces, groups (G₁, G₂, G₃) of assemblies (D₁, D₂, D₃) of light-emitting diodes resting on the first surface among which first and second assemblies (D₁, D₂), each group comprising at least one assembly of light-emitting diodes connected in parallel between first and second terminals, each assembly (D₁, D₂, D₃) of light-emitting diodes comprising a wire semiconductor element (20₁, 20₂, 20₃) or a plurality of wire semiconductor elements or several wire semiconductor elements connected in parallel, the first assembly (D₁) being adapted to emit light at a first wavelength and the second assembly (D₂) being adapted to emit light at a second wavelength different from the first wavelength, the first integrated circuit further comprising, in the support, first elements (52) of lateral electric insulation of portions of the support around each assembly and, on the second surface, for each group, at least one first conductive pad (46₁, 46₂, 46₃) connected to the first terminal of the group and a second conductive pad (48₁, 48₂, 48₃) connected to the second terminal of the group; and
a second integrated circuit (7) comprising third and fourth opposite surfaces, third conductive pads (70) on the third surface electrically connected to the first and second conductive pads,
the first integrated circuit being fixed to the third surface of the second integrated circuit.

2. The optoelectronic device of claim 1, wherein the support comprises a substrate (10) comprising fifth and sixth opposite surfaces (14, 12), the light-emitting diodes being located on the side of the fifth surface (14) and comprising, for each assembly (D₁, D₂, D₃), at least one second conductive element (40₁, 40₂, 40₃) insulated from the substrate and crossing the substrate from the fifth surface to the sixth surface (12) and connected to one of the first conductive pads.

3. The optoelectronic device of claim 2, wherein the first elements (52) are capable of laterally electrically insulating portions (53₁, 53₂, 53₃) of the substrate (10) underlying the light-emitting diodes of each assembly (D₁, D₂, D₃).

4. The optoelectronic device of claim 3, wherein the first elements (52) comprise insulating walls extending in the substrate from the fifth surface to the sixth surface.

5. The optoelectronic device of any of claims 1 to 4, wherein the second integrated circuit (7) comprises thermal drains (92) crossing the second integrated circuit from the third surface to the fourth surface.

6. The optoelectronic device of any of claims 1 to 5, comprising, for each assembly (D₁, D₂, D₃), an electrode layer (30₁, 30₂, 30₃) covering each light-emitting diode of said assembly and further comprising a conductive layer (32₁, 32₂, 32₃) covering the electrode layer around the light-emitting diodes of said assembly.

7. The optoelectronic device of claims 2 and 6, wherein the second element (40₁, 40₂, 40₃) is in contact with conductive layer (32₁, 32₂, 32₃) or electrode layer (30₁, 30₂, 30₃).

8. The optoelectronic device of any of claims 1 to 7, wherein the second integrated circuit (7) comprises a rectifying circuit (100) intended to receive an AC voltage (V_{ALIM}).

9. The optoelectronic device of any of claims 1 to 8, wherein the first integrated circuit (6) comprises N groups (G₁, Gᵢ, G_{N}) of assemblies of light-emitting diodes, where N is an integer varying from 2 to 200, and wherein the second integrated circuit (7) comprises N-1 switches (SW₁, SWᵢ, SW_{N-1}), each switch being connected to the first terminal or the second terminal of one of said groups.

10. The optoelectronic device of claim 9, wherein the second integrated circuit (7) comprises N current sources (108₁, 108ᵢ, 108_{N}), each of N-1 of said current sources being connected to the first or second terminals of one of said groups (G₁, Gᵢ, G_{N}).

11. The optoelectronic device of any of claims 1 to 10, comprising fourth conductive pads (84) on the fourth surface.

12. The optoelectronic device of any of claims 1 to 11, further comprising a third assembly (D₃) of light-emitting diodes adapted to emit light at a third wavelength different from the first wavelength and from the second wavelength.
